# EUROPEAN PATENT APPLICATION

(11) **EP 4 475 184 A1**
(43) Date of publication of application: **11.12.2024**
(21) Application number: 24174567.8
(22) Date of filing: 07.05.2024
(51) Int. Cl.: H01L 25/075

(54) **LIGHTING APPARATUS**

(30) Priority: 24.05.2023 CN 202321278299 U
(71) Applicant: Leedarson Lighting Co., Ltd., Zhangzhou, Fujian 363999 (CN)
(72) Inventor: JIANG, Hongkui, Zhangzhou, Fujian 363999 (CN); ZHENG, Yongshu, Zhangzhou, Fujian 363999 (CN)
(74) Representative: Chimini, Francesco

(57) **Abstract**

A lighting apparatus includes a substrate plate, multiple LED chips, multiple chip wires, a first wrapping layer and a terminal pin. The substrate plate includes a polyester thermal conductive material. The substrate plate is flexible when an external force is applied to the substrate plate. The transmittance of the substrate plate is more than 40%. Multiple LED chips are disposed on a front side of the substrate plate. Multiple chip wires are used for electrically connecting the multiple LED chips. The first wrapping layer is attached to the front side of the substrate plate for enclosing the multiple LED chips and the multiple chip wires. The terminal pin disposed at a peripheral side of the substrate plate for conducting a driving current to the multiple LED chips.

## Description

### FIELD

The present invention is related to a lighting apparatus, and more particularly related to a lighting apparatus with enhanced light effect.

### BACKGROUND

Light Emitting Diodes (LEDs) have revolutionized the lighting industry with their remarkable energy efficiency and longevity. Unlike traditional incandescent and fluorescent lights, LEDs do not rely on the heating of a filament or the excitation of gases to produce light. Instead, they generate light through the movement of electrons in a semiconductor material, which emits photons when the electrons fall to a lower energy state. This process, known as electroluminescence, allows LEDs to convert electricity into light more efficiently and with less heat production.

The adaptability of LED technology extends across a wide range of lighting applications. LEDs are used in residential, commercial, and industrial settings for general lighting purposes due to their versatility and energy-saving properties. They are particularly favored in environments where long-term cost savings through reduced energy consumption and lower maintenance costs are a priority. Moreover, the ability to precisely control the intensity and color of LED lights adds a layer of functionality that traditional lighting technologies cannot match.

LEDs have also become the preferred choice for various specialized lighting applications. In automotive industries, for instance, LEDs are used extensively for headlights, interior lights, and signal lights. Their compact size allows for creative design and better integration into modern vehicle aesthetics. Furthermore, the rapid response time of LEDs enhances safety by providing immediate illumination, which is critical in signaling devices.

In consumer electronics, LEDs are indispensable for backlighting in mobile phones, laptops, and televisions. The small footprint and low power consumption of LEDs enable sleeker device designs and improved battery efficiency. Additionally, LEDs are capable of producing a wide spectrum of colors, making them ideal for display technologies that require high color accuracy and vibrancy.

The role of LEDs in outdoor lighting applications, such as street lights and architectural lighting, is equally significant. LEDs offer superior durability and resistance to temperature changes and vibrations, which are essential characteristics for outdoor environments. Their directional lighting capability also means that light pollution can be minimized, making LEDs an environmentally friendly option for urban lighting.

The widespread adoption of LED technology in various lighting devices is a testament to its superior characteristics over traditional lighting methods. With ongoing advancements in LED technology, their applications continue to expand, further entrenching LEDs as a pivotal component in the future of lighting. This broad utility and evolving nature of LED technology make it a key area of interest for continued research and development in the field of lighting technology.

The traditional tungsten filament bulb, a hallmark of early 20th-century innovation, played a central role in lighting up homes and cities around the world. These bulbs worked on a simple yet fascinating principle: electricity was passed through a thin tungsten wire (filament), which then heated up to a point where it glowed and emitted light. The filament was encased in a glass bulb, which was either vacuum-sealed or filled with an inert gas to prevent the tungsten filament from oxidizing and breaking down.

Despite its widespread use, the tungsten filament bulb was known for its inefficiency. A significant portion of the energy consumed by these bulbs was emitted as heat rather than light, leading to a poor conversion rate of electrical power to visible light. This inefficiency was a well-accepted trade-off for many years, partly due to the lack of better alternatives and partly because of the manufacturing and material costs involved in developing more efficient lighting solutions.

However, the warm glow of tungsten filament bulbs has cemented its place in the collective memory of many. The soft, yellowish light emitted by these bulbs is often associated with a sense of nostalgia and warmth, reminiscent of cozy evenings at home or in intimate public spaces. This emotional attachment has preserved the demand for tungsten bulbs, even in an era dominated by more energy-efficient lighting technologies like LEDs and compact fluorescent lamps.

In recent times, there has been a resurgence in the popularity of tungsten filament bulbs, particularly among those looking to recreate vintage or retro aesthetics in interior design. These bulbs are celebrated not just for their functionality but for their classic visual appeal, evoking a past era of simplicity and classic design. Although they are not as energy-efficient as their modern counterparts, the enduring charm of tungsten filament bulbs continues to hold a special place in the hearts of many, bridging the gap between past and present lighting technologies.

In recent years, LED technology has advanced to the point where it can emulate the visual effects of traditional tungsten filament bulbs. This is achieved through innovations in LED color temperature and the use of phosphor coatings that can mimic the warm, amber glow typically associated with tungsten bulbs. LED manufacturers have also developed bulbs with visible filaments, structured with tiny LED emitters lined up in a way that resembles the old-fashioned filament strands. These design advancements allow LEDs not only to replicate the aesthetic qualities of tungsten bulbs but to do so with far greater energy efficiency and longevity.

However, several design challenges remain to be addressed before LED bulbs can fully replace traditional tungsten filament bulbs in every aspect. One significant issue is the quality of light diffusion. Tungsten bulbs naturally provide a uniform, omnidirectional light that many find pleasing in residential and hospitality settings. Current LED technology, while improving, often results in light that can feel more directed or harsh, lacking the soft, diffuse quality of incandescent bulbs. Engineers and designers are continually working on refining the optics within LED bulbs to better disperse light and soften its output.

Another area of concern is the electronic complexity associated with LEDs. Unlike the simple design of tungsten bulbs, LEDs require drivers and circuitry to regulate power, which can introduce points of failure not present in the straightforward electrical design of traditional bulbs. These components can also generate heat, necessitating careful thermal management to ensure the longevity of the bulb. Designing these systems to be reliable and fit within the form factor of traditional bulb shapes without compromising performance is an ongoing challenge.

Furthermore, there is the issue of cost and consumer acceptance. While the prices of LED bulbs have decreased significantly, the upfront cost can still be higher than that of traditional bulbs, posing a barrier to widespread adoption. Additionally, despite technological advancements, some consumers remain skeptical about the ability of LEDs to truly replicate the feel of tungsten lighting in terms of ambiance and color rendering. Overcoming these hurdles involves not only continued improvements in LED technology but also effective communication about the benefits and advancements to the public.

By addressing these technical and perceptual challenges, LED technology can move closer to becoming the standard for those seeking the nostalgic appeal of tungsten filament bulbs without sacrificing the benefits of modern efficiency and sustainability.

### SUMMARY

In some embodiments, a lighting apparatus includes a substrate plate, multiple LED chips, multiple chip wires, a first wrapping layer and a terminal pin.

The substrate plate includes a polyester thermal conductive material.

The substrate plate is flexible when an external force is applied to the substrate plate.

The transmittance of the substrate plate is more than 40%.

Multiple LED chips are disposed on a front side of the substrate plate.

Multiple chip wires are used for electrically connecting the multiple LED chips.

The first wrapping layer is attached to the front side of the substrate plate for enclosing the multiple LED chips and the multiple chip wires.

The terminal pin disposed at a peripheral side of the substrate plate for conducting a driving current to the multiple LED chips.

In some embodiments, the polyester thermal conductive material is Polyethylene Terephthalate (PET).

In some embodiments, the polyester thermal conductive material is Polyethylene Naphthalate (PEN).

In some embodiments, the polyester thermal conductive material is Polybutylene Terephthalate (PBT).

In some embodiments, the transmittance of the substrate plate is more than 80%.

In some embodiments, there are more than two terminal pins for conducting electrical signals via multiple signal paths to the multiple LED chips.

In some embodiments, a contact portion for coupling the chip wire and the LED chip is covered with an encapsulant.

In some embodiments, the transmittance of the the encapsulant is more than 40%.

In some embodiments, where a difference of a first coefficient of thermal expansion of the encapsulant and a second coefficient of thermal expansion of the chip wire is less than 10% of second coefficient of thermal expansion of the chip wire between 10 degree Celsius and 150 degree Celsius.

In some embodiments, the multiple LED chips are connected in series.

In some embodiments, a portion of the multiple LED chips are connected in parallel.

In some embodiments, the substrate plate has a conductive track for conducting the driving current from the terminal pin to the multiple LED chips.

In some embodiments, the conductive track keeps the shape of the substrate plate while the external force is released.

In some embodiments, the substrate plate has a support layer and a polyester layer.

The polyester layer is composed of the polyester thermal conductive material.

The polyester layer and the support layer are stacked and coupled together.

The polyester layer and the support layer have a stronger structure strength to keep shape than the polyester layer when the external force is applied to bend the substrate plate.

In some embodiments, the support layer is a metal mesh with gaps for light to pass through.

In some embodiments, the lighting apparatus may also include a front fluorescent layer covering the multiple LED chips.

In some embodiments, the lighting apparatus may also include a back fluorescent layer attaching to a back side of the substrate plate.

The materials of the front fluorescent layer and the back fluorescent layer are different.

In some embodiments, multiple lens units are disposed on the substrate plate for changing light paths of the multiple LED chips.

In some embodiments, the substrate plate has a connector for attaching the substrate plate to a bracket.

The bracket is used for keeping the bending shape of the substrate plate.

In some embodiments, the bracket is thermally coupled to a heat sink.

### BRIEF DESCRIPTION OF DRAWINGS

Fig. 1 illustrates a side view of a light source module embodiment.
Fig. 2 illustrates a top view of of the example in Fig. 1.
Fig. 3 illustrates component connection in a light source module.
Fig. 4 illustrates a zoom-up view of a chip wire for connecting two LED chips.
Fig. 5 illustrates another layout of a light source module
Fig. 6 illustrates another layout of a light source module.
Fig. 7 shows a light source module example.
Fig. 8 shows flexible feature of a light source module.
Fig. 9 shows different arrangement for terminal pins.
Fig. 10 shows a track example.
Fig. 11 shows a support layer example.
Fig. 12 shows a light bulb example.

### DETAILED DESCRIPTION

In some embodiments, a lighting apparatus includes a substrate plate 610, multiple LED chips 601, 602, multiple chip wires 603, a first wrapping layer 604 and a terminal pin 605.

The substrate plate 610 includes a polyester thermal conductive material.

The substrate plate 610 is flexible when an external force is applied to the substrate plate.

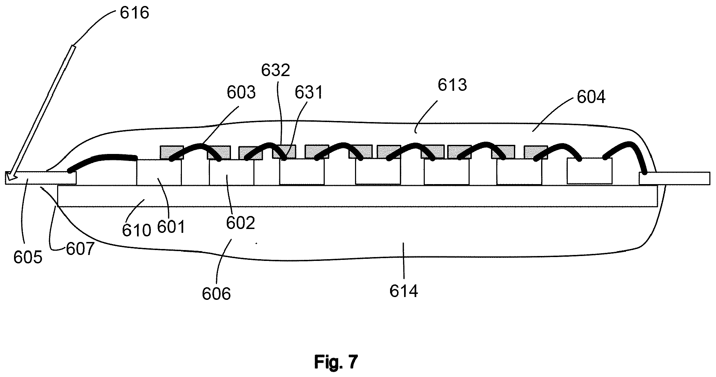

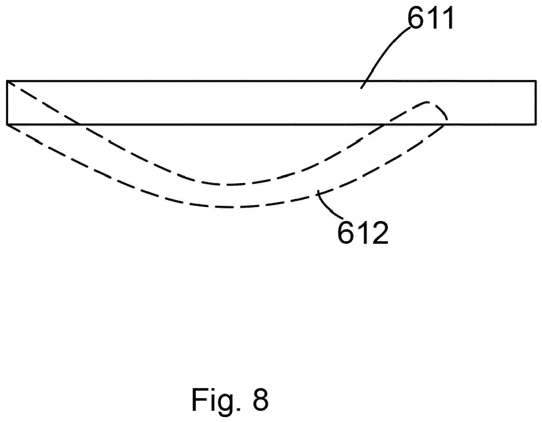

Please see Fig. 8. In Fig. 8, a light source module 611 like the one of Fig. 7 explained above is bendable to be flexible while an external force applies to the light source module 611 to the new shape 612, depicted with dashed lines.

The transmittance of the substrate plate is more than 40%, which mean that more than 40% of light can pass through the substrate plate in this embodiment. Please note, however, the features mentioned in this application may still be integrated with a non-transparent substrate.

Multiple LED chips 601, 602 are disposed on a front side 613 of the substrate plate 610.

Multiple chip wires 603 are used for electrically connecting the multiple LED chips 601, 602.

The first wrapping layer 604 is attached to the front side 613 of the substrate plate 610 for enclosing the multiple LED chips 601, 602 and the multiple chip wires 603.

The terminal pin 605 disposed at a peripheral side 607 of the substrate plate 610 for conducting a driving current 616 to the multiple LED chips 601, 602.

In some embodiments, the polyester thermal conductive material is Polyethylene Terephthalate (PET).

In some embodiments, the polyester thermal conductive material is Polyethylene Naphthalate (PEN).

In some embodiments, the polyester thermal conductive material is Polybutylene Terephthalate (PBT).

In some embodiments, the transmittance of the substrate plate is more than 80%.

In some embodiments, there are more than two terminal pins for conducting electrical signals via multiple signal paths to the multiple LED chips.

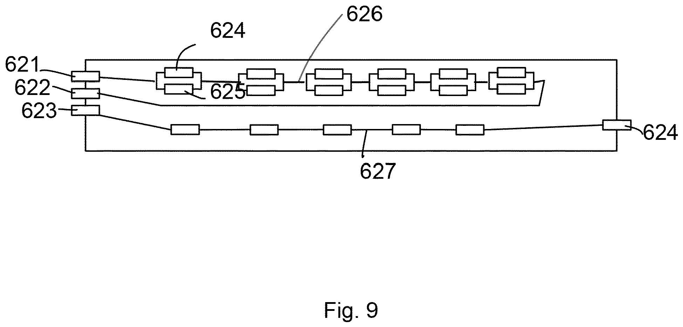

In Fig. 9, there are two signal paths 626, 627 and there are four terminal pins 621, 622, 623 and 624.

In the embodiment illustrated in Fig. 9, there are two signal paths. In the first signal path 626, two terminal pins 621 are used for guiding driving current to the LED chips. In the first signal path 626, two LED chips 624, 625 are connected in parallel forming a unit. Multiple such units are connected in series.

In the second signal path 627, LED chips are connected in series.

In Fig. 7, a contact portion 631 for coupling the chip wire and the LED chip is covered with an encapsulant 632.

In some embodiments, the transmittance of the the encapsulant 632 is more than 40%.

In some embodiments, where a difference of a first coefficient of thermal expansion of the encapsulant and a second coefficient of thermal expansion of the chip wire is less than 10% of second coefficient of thermal expansion of the chip wire between 10 degree Celsius and 150 degree Celsius.

This design ensures that during the LED emits light, its heat causes temperature increasing, which may further cause structure broken due to thermal expansion.

In some embodiments, the multiple LED chips are connected in series. Fig. 9 shows such an example.

In some embodiments, a portion of the multiple LED chips are connected in parallel. Fig. 9 shows such an example.

In some embodiments, the substrate plate has a conductive track for conducting the driving current from the terminal pin to the multiple LED chips.

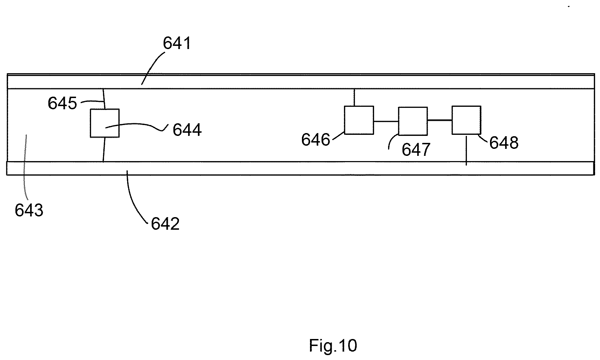

In Fig. 10, there are two conductive tracks 641, 642 disposed on the substrate plate 643.

There are various ways for using the conductive tracks 641, 642. For example, the LED chip 644 uses a chip wire 645 coupling to the conductive track 641.

On the right side of Fig. 10, three LED chips 646, 647, 648 are connected in series with chip wires and then coupled to the conductive tracks 641, 642 with additional chip wires.

In some embodiments, the conductive track keeps the shape of the substrate plate while the external force is released. As mentioned above, the main part of the substrate plate may be made with flexible polyester material. To keep the shape of the substrate plate stable, the conductive track which is made of metal material is good to provide support to keep the desired shape of the substrate plate unchanged unless another external force is applied thereon.

In some embodiments, the substrate plate has a support layer and a polyester layer.

The polyester layer is composed of the polyester thermal conductive material.

The polyester layer and the support layer are stacked and coupled together.

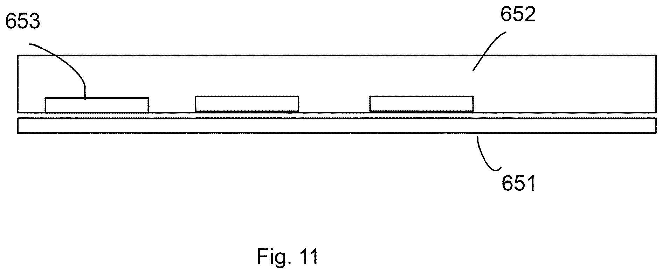

Fig. 11 shows such an example. In Fig. 11, the support layer 651 and the polyester layer 652 are coupled together. The support layer 651 provides a structure strength to help the shape of the total substrate plate unchanged while no external force is applied thereon while keeping the shape flexible when an external force is applied thereon.

The polyester layer and the support layer have a stronger structure strength to keep shape than the polyester layer when the external force is applied to bend the substrate plate.

In some embodiments, the support layer is a metal mesh with gaps for light to pass through. The metal mesh refers to a metal sheet with grid gaps for light to pass through.

In some embodiments, the lighting apparatus may also include a front fluorescent layer covering the multiple LED chips. In Fig. 7, the wrapping layer 604 may be impelmented with such front fluorescent layer.

In some embodiments, the lighting apparatus may also include a back fluorescent layer attaching to a back side of the substrate plate. In Fig. 7, the wrapping layer 614 may be implemented with such back fluorescent layer.

The materials of the front fluorescent layer and the back fluorescent layer are different.

In some embodiments, multiple lens units are disposed on the substrate plate for changing light paths of the multiple LED chips.

Fig. 11 shows that the lens 653 is integrated with the substrate plate, e.g. to change certain area with different curverture surface. Such design provides an enhanced way without adding further cost to change light paths of the LED chips.

In some embodiments, the substrate plate has a connector for attaching the substrate plate to a bracket.

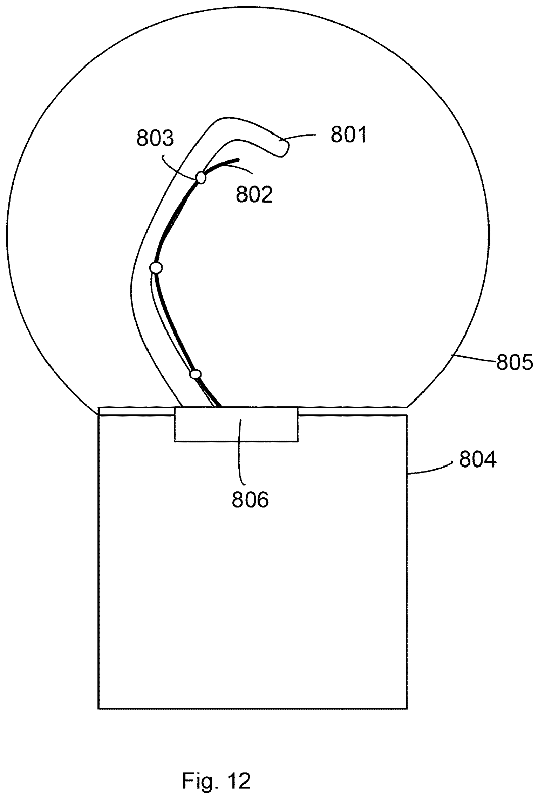

In Fig. 12, a lighting apparatus includes a driver part 804 for converting an external power source to a driving currents supplied to LED chips disposed on the light source module 801. The light source module 801 has connectors 803 on its substrate plate for coupling to a bracket 802, e.g. metal bar for keeping the desired shape of the light source module 801. The light source module 801 is enclosed by a bulb shell 805.

The bracket 802 is used for keeping the bending shape of the substrate plate.

In some embodiments, the bracket is thermally coupled to a heat sink 806.

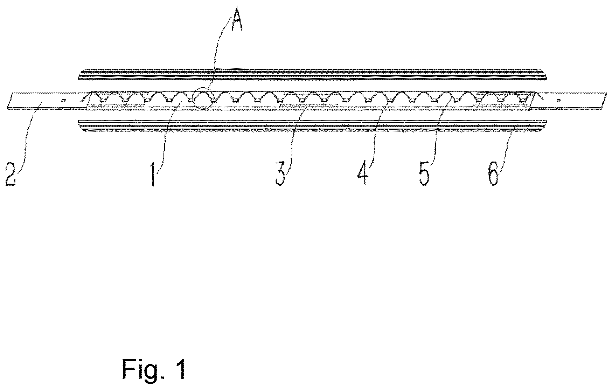

Please refer to Figures 1 to 3 for an explanation of the filament substrate provided in the embodiments of this application. The filament substrate includes interconnected transparent substrates 1 and conductive terminals 2. The transparent substrate 1 serves as the packaging carrier for the chip 4, enhancing the mechanical strength of the filament. Since the transparent substrate 1 is made from highly transparent material, it does not obstruct the light emitted by the chip 4 when mounted on it, thereby improving the backlight penetration rate. At least two conductive terminals 2 are positioned on one or both ends of the transparent substrate 1 for connection to an external power source.

The chip mounting surface of the transparent substrate 1 is equipped with at least one conductive cooling zone. The shape, position, and number of these conductive cooling zones are determined based on the distribution of the chips 4 on the filament substrate and the heat distribution during illumination. Specifically, the conductive cooling zone features a conductive cooling layer 3, which is formed by applying high heat radiation molecular materials to the chip mounting surface of the transparent substrate 1 using coating equipment, thereby enhancing the heat radiation of the transparent substrate 1 and maximizing its cooling capacity.

The conductive cooling layer 3 is made of transparent material, which minimizes the impact of this layer on the light output efficiency of the filament when applied to the transparent substrate 1. When the transparent substrate 1 serves as the packaging carrier for the chip 4, commonly used chips include face-up chips 41 and flip-chips 42, each requiring different configurations of the conductive cooling zones based on the type of chip.

Refer to Figure 1, in one embodiment of this application, when employing the face-up chip packaging process, multiple face-up chips 41 are arranged along the length direction of the transparent substrate 1, i.e., the left-right direction in Figure 1, positioned in the middle of the transparent substrate 1, with conductive cooling layers 3 distributed on both sides of the transparent substrate. This configuration enhances the cooling capacity of the transparent substrate 1 while also reducing the impact of the conductive cooling layers 3 on the filament's light output efficiency.

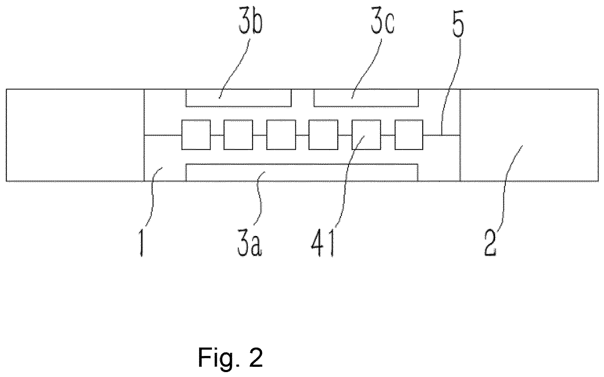

In another embodiment, please refer to Figure 2, when using the face-up chip packaging process, the first conductive cooling layer 3a, the second conductive cooling layer 3b, and the third conductive cooling layer 3c are respectively located on both sides of the transparent substrate 1. These layers are used to enhance the cooling ability in different areas of the transparent substrate 1. The heat generated by the chip 4 during the illumination process is evenly diffused through the transparent substrate 1 and the conductive cooling layers, thereby improving the light conversion efficiency of the chip 4 and enhancing the light output efficiency.

In addition, since the conductive cooling layer 3 is conductive, the face-up chips 41 can be connected to the conductive cooling layer 3 via conductive wires 5, enriching the connection methods among the face-up chips 41.

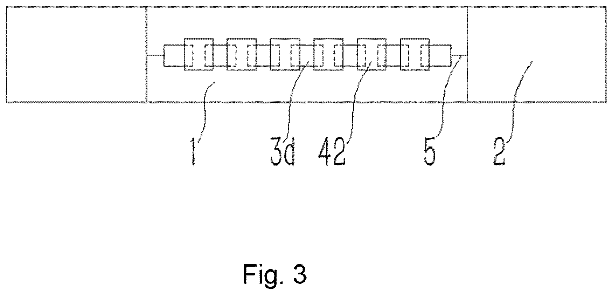

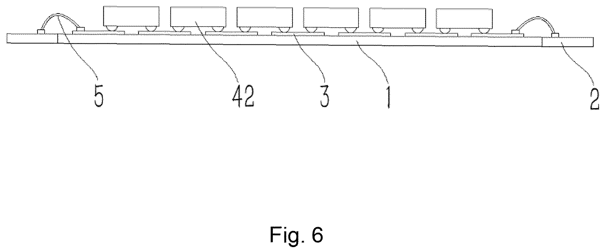

In another embodiment of this application, please refer to Figures 3 and 6, when using the flip-chip packaging process, multiple flip-chips 42 are arranged along the length direction of the transparent substrate 1, i.e., the left-right direction in Figure 3, and positioned in the middle of the transparent substrate 1. The conductive cooling zone is located in the middle of the transparent substrate 1 and beneath the flip-chips 42. The two electrodes of each flip-chip 42 are connected to adjacent fourth conductive cooling layers 3d, replacing the copper wires on the substrate with multiple transparent conductive cooling layers 3. This avoids the issue of the flip-chips 42 being opaque on the back due to copper wire obstructions while also enhancing the cooling capacity of the transparent substrate 1.

Compared to existing technologies, the filament substrate provided by this application can enhance the mechanical strength of the filament after packaging when using the transparent substrate 1 as a packaging carrier for face-up chips 41. By incorporating conductive cooling layers on the transparent substrate 1, its cooling capacity is enhanced, facilitating the timely dissipation of heat generated by the chip 4 during illumination and improving the light conversion efficiency of the chip 4. The conductivity of the cooling layers 3 allows for multiple connection points for conductive wires 5 during the packaging of face-up chips 41, enriching the series and parallel connection methods among the face-up chips 41. When packaging flip-chips 42, the use of multiple conductive cooling layers 3 in place of copper wires not only enhances the cooling capacity of the transparent substrate 1 but also avoids the issue of light obstruction caused by copper wires on the back of the flip-chips 42.

The material for the transparent substrate 1 can be a high-transparency, high-temperature resistant insulating material available in existing technologies. This insulating material needs to possess certain rigidity, hardness, and toughness to meet the application requirements of different filaments.

In a preferred embodiment of this application, the material of the transparent substrate 1 is a polyester film suitable for the preparation of flexible filaments. The mechanical properties of polyester film, including rigidity, hardness, and toughness, as well as its high and low temperature resistance, meet the various flexibility and functional requirements needed during the packaging of flexible filaments.

The material for the conductive cooling layer 3 can be selected from existing technologies that possess both high thermal radiation properties and conductivity, which are transparent materials used to enhance the cooling performance of the transparent substrate 1 and enrich the connection methods of chips 4 on the transparent substrate 1.

In a preferred embodiment of this application, graphene, known for its conductivity and ease of forming films, is used to coat the chip mounting surface of the transparent substrate 1 to create the conductive cooling layer 3. Due to the excellent toughness of graphene, the conductive cooling layer 3 made from it also exhibits good toughness, allowing it to bend along with the transparent substrate 1, making it suitable for the production of flexible filaments.

Graphene has excellent thermal conductivity, with thermal conductivity values ranging from 600 W/mK to 5300 W/mK, which can significantly enhance the cooling capacity of the transparent substrate 1. At the same time, graphene also has good optical properties, with an absorption rate of about 2.3% across a wide wavelength range, making it almost transparent and minimizing the impact of the conductive cooling layer 3 on the light output efficiency of the transparent substrate 1.

Please refer to Figures 1 through 6, this application also provides a type of filament that includes multiple chips 4 arranged in the middle of the chip mounting surface along the length of the transparent substrate 1, with any two chips 4 connected in series or parallel.

In another embodiment of this application, please refer to Figures 1 through 6, the filament also includes multiple conductive wires 5, one end of each conductive wire 5 is connected to either a chip 4, a conductive cooling layer 3, or a conductive terminal 2, and the other end is connected to another chip 4, conductive cooling layer 3, or conductive terminal 2, with the specific connection method determined based on the manufacturing requirements of the filament.

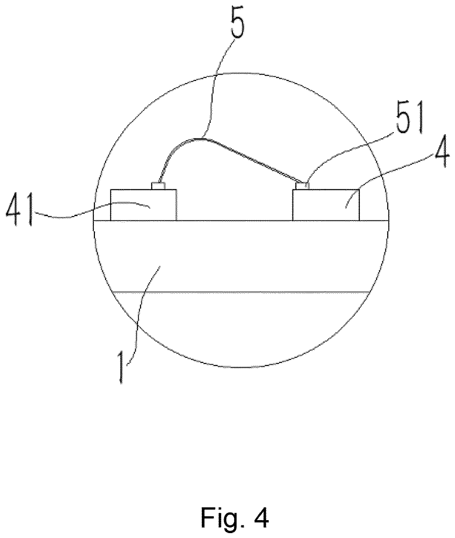

In another embodiment of this application, refer to Figures 1 and 4, the filament substrate is a flexible filament substrate, and protective structures 51 are placed at both connection ends of conductive wire 5 to enhance the mechanical strength of the connection points of the wire, preventing breakage at the connection ends of the conductive wire 5 due to twisting of the flexible filament during production, thus preventing light source failure and increasing the lifespan of the flexible filament.

The material for the protective structure 51 can be selected from existing technologies that are colorless, have high transparency, and have a coefficient of thermal expansion consistent with or very close to that of conductive wire 5, minimizing the pulling effect caused by thermal expansion during the filament's illumination process. In one preferred embodiment of this application, the material for the protective structure 51 is protective glue. In another preferred embodiment, the material for the protective structure 51 is silicone resin.

When preparing the protective structure 51, adding a silicone resin gel at the connection point of the conductive wire 5 and chip 4 helps to disperse the external forces at the connection ends of the conductive wire 5 after the gel cures, protecting the connection ends and increasing the resistance of the wire material to external forces.

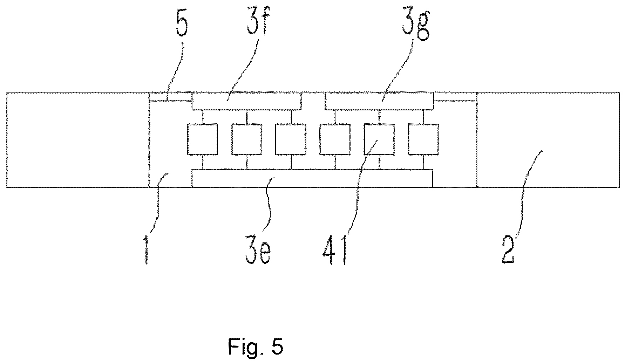

In another embodiment of this application, please refer to Figure 5, during the packaging process of the face-up chips 41, they are connected to the conductive cooling layer 3 via conductive wires 5, enabling the series connection of two groups of face-up chips 41. One group includes three face-up chips 41 connected in parallel between the sixth conductive cooling layer 3f and the fifth conductive cooling layer 3e, and the other group includes three face-up chips 41 connected in parallel between the fifth conductive cooling layer 3e and the seventh conductive cooling layer 3g. Using different conductive cooling layers 3 as connection hubs for face-up chips 41 enriches the series and parallel connection configurations, meeting various filament manufacturing requirements.

In another embodiment of this application, please refer to Figures 1 and 2, the conductive terminal 2 connects to chip 4 via conductive wire 5; the conductive terminal 2 is directly connected to the chip 4 located at the end of the transparent substrate 1 through conductive wire 5.

In another embodiment, refer to Figure 3, during the packaging of the flip-chip 42 located at the end of the transparent substrate 1, it is electrically connected to the fourth conductive cooling layer 3d, also located at the same end of the transparent substrate 1. The conductive terminal 2 connects to this fourth conductive cooling layer 3d via conductive wire 5, enabling the series connection of multiple flip-chips 42 and allowing the conductive terminal 2 to activate this series circuit.

In another embodiment, refer to Figure 5, during the packaging of face-up chips 41, two groups of series-connected face-up chips 41 are connected to the positive and negative conductive terminals 2 via the sixth conductive cooling layer 3f and the seventh conductive cooling layer 3g, respectively.

In another embodiment, refer to Figure 1, the filament also includes an encapsulation layer 6, which wraps around the filament substrate, chips 4, and conductive wires 5, providing external protection for these components.

The material for encapsulation layer 6 can be selected from existing technologies such as epoxy resin encapsulation adhesive, silicone encapsulation adhesive, polyurethane encapsulation adhesive, and fluorescent adhesive. In a preferred embodiment of this application, the material for encapsulation layer 6 is fluorescent adhesive. When preparing this encapsulation layer 6, a certain proportion of fluorescent powder is mixed with materials like epoxy resin adhesive to form the fluorescent adhesive. Using this fluorescent adhesive for encapsulation can enhance the light output efficiency and improve the luminous effect of the filament. At the same time, encapsulation layer 6 wraps around the exterior of the conductive wire 5, directly enveloping the wire material and relying on the elastic buffering action of the encapsulation gel to protect the wire body of conductive wire 5, making it less likely to break. Both ends of conductive wire 5 have protective structures 51, specifically a passivating gel layer wrapped around the connection ends of conductive wire 5, which helps prevent breakage at these points. The exterior of conductive wire 5 is protected by a layer of fluorescent adhesive, preventing breakage of the wire body, with protective structures 51 and encapsulation layer 6 providing double protection for conductive wire 5.

This application also provides a type of lighting fixture that includes the filament described in any of the embodiments above. The conductive terminals 2 at both ends of the filament connect to the core column in the light fixture; the outer cover of the filament is a transparent or translucent light bulb casing, which can be in shapes such as spherical or candle-like.

In another embodiment of this application, the filament is prepared through the following steps:
Step 1: Prepare a polyester film transparent substrate 1, preferably in a long strip shape for the transparent substrate 1.
Step 2: Connect the conductive terminals 2 to the transparent substrate 1 using adhesive bonding, claw connections, or crimping methods.
Step 3: Apply graphene material to the chip mounting surface's conductive cooling area on the transparent substrate 1 using a coating device, forming the conductive cooling layer 3.
Step 4: During the packaging of the face-up chips 41, position multiple face-up chips 41 in the middle of the transparent substrate 1, and solder conductive wires 5 to establish connections between the components. Apply reinforcing adhesive at the connection ends of the conductive wires 5 (i.e., the soldering points), and form protective structures 51 after the adhesive cures.
   During the packaging of flip-chips 42, connect the electrodes of the flip-chips 42 to the conductive cooling layer, solder conductive wires 5 between the conductive cooling layer 3 and conductive terminals 2, apply reinforcing adhesive at the connection ends of the conductive wires 5, and form protective structures 51 after the adhesive cures.
Step 5: Prepare the encapsulation layer 6 outside the filament substrate, chips 4, and conductive wires 5 to complete the fabrication of the filament.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings.

The embodiments were chosen and described in order to best explain the principles of the techniques and their practical applications. Others skilled in the art are thereby enabled to best utilize the techniques and various embodiments with various modifications as are suited to the particular use contemplated.

Although the disclosure and examples have been fully described with reference to the accompanying drawings, it is to be noted that various changes and modifications will become apparent to those skilled in the art. Such changes and modifications are to be understood as being included within the scope of the disclosure and examples as defined by the claims.

## Claims

1. A lighting apparatus comprising:
a substrate plate (610) comprising a polyester thermal conductive material, wherein the substrate plate (610) is flexible when an external force is applied to the substrate plate (610), wherein a transmittance of the substrate plate (610) is more than 40%;
multiple LED chips (601, 602) disposed on a front side of the substrate plate (610);
multiple chip wires (603) for electrically connecting the multiple LED chips (601, 602);
a first wrapping layer (604) attached to the front side of the substrate plate (610) for enclosing the multiple LED chips (601, 602) and the multiple chip wires (603); and
a terminal pin (605) disposed at a peripheral side of the substrate plate (610) for conducting a driving current to the multiple LED chips (601, 602).

2. The lighting apparatus of claim 1, wherein the polyester thermal conductive material is Polyethylene Terephthalate (PET).

3. The lighting apparatus of claim 1, wherein the polyester thermal conductive material is Polyethylene Naphthalate (PEN).

4. The lighting apparatus of claim 1, wherein the polyester thermal conductive material is Polybutylene Terephthalate (PBT).

5. The lighting apparatus of any one of claims 1 to 4, wherein a contact portion (631) for coupling the chip wire and the LED chip is covered with an encapsulant.

6. The lighting apparatus of claim 5, where a difference of a first coefficient of thermal expansion of the encapsulant and a second coefficient of thermal expansion of the chip wire is less than 10% of second coefficient of thermal expansion of the chip wire between 10 degree Celsius and 150 degree Celsius.

7. The lighting apparatus of any one of claims 1 to 6, wherein the substrate plate (610) has a conductive track (641, 642) for conducting the driving current from the terminal pin (605) to the multiple LED chips (601, 602).

8. The lighting apparatus of claim 1, wherein the substrate plate (610) has a support layer (651) and a polyester layer (652), wherein the polyester layer (652) is composed of the polyester thermal conductive material, wherein the polyester layer (652) and the support layer (651) are stacked and coupled together, wherein the polyester layer (652) and the support layer (651) have a stronger structure strength to keep shape than the polyester layer (652) when the external force is applied to bend the substrate plate (610).

9. The lighting apparatus of claim 8, wherein the support layer (651) is a metal mesh with gaps for light to pass therethrough.

10. The lighting apparatus of any one of claims 1 to 9, wherein multiple lens units are disposed on the substrate plate (610) for changing light paths of the multiple LED chips (601, 602).
